Europäisches Patentamt

European Patent Office

Office européen des brevets

(11) Veröffentlichungsnummer : **0 012 207**
**B1**

(19)

(12) # EUROPÄISCHE PATENTSCHRIFT

(45) Veröffentlichungstag der Patentschrift :
11.05.83

(21) Anmeldenummer : 79104232.8

(22) Anmeldetag : 31.10.79

(51) Int. Cl.³ : **G 11 C   9/06**, G 06 F 13/00,
**G 11 D   1/00**

(54) **Speicherhierarchie mit Ladungsverschiebungsspeicher.**

(30) Priorität : 12.12.78 DE 2853501

(43) Veröffentlichungstag der Anmeldung :
25.06.80 Patentblatt 80/13

(45) Bekanntmachung des Hinweises auf die Patenterteilung : 11.05.83 Patentblatt 83/19

(84) Benannte Vertragsstaaten :
DE FR GB

(56) Entgegenhaltungen :
FR A 2 326 740
US A 3 839 704
COMPUTER DESIGN, Jahrgang 10, Nr. 2,
Februar 1971, Winchester, US, M. HOFF et al. :
« Operation and applications of MOS shift registers », Seiten 57-62
COMMUNICATIONS OF THE ACM, Jahrgang 21,
Nr. 5, Mai 1978, New York, US, R. SITES : « Optical shift strategy for a block-transfer CCD-
memory », Seiten 423-425
IBM TECHNICAL DISCLOSURE BULLETIN, Jahrgang 21, Nr. 4, September 1978, Armonk, US,
C. SCHUENEMANN : « Prepaging in memory hierarchies », Seiten 1512-1513
PROCEEDINGS OF THE NATIONAL COMPUTER
CONFERENCE, Band 45, 7-10, Juni 1976,
A.F.I.P.S. Montvale, New York, US, P. SCHNEI-
DER : « Working set restoration — A method to
increase the performance of multilevel storage
hierarchies », Seiten 373-380

(73) Patentinhaber : International Business Machines Corporation

Armonk, N.Y. 10504 (US)

(72) Erfinder : Schünemann, Claus, Dr.
Cheruskerstrasse 27
D-7036 Schönaich (DE)

(74) Vertreter : Teufel, Fritz, Dipl.-Phys.
Schönaicher Strasse 220
D-7030 Böblingen (DE)

(56) Entgegenhaltungen :
ELECTRICAL DESIGN NEWS, Jahrgang 14, Nr.
20, 15. Oktober 1969, Boston, US, D. MARCIAN et
al. : « Solid state memory offers new organizations », Seiten 55-61
IBM TECHNICAL DISCLOSURE BULLETIN, Jahrgang 21, Nr. 11, April 1979, Armonk, US,
F. AICHELMANN : « DASD access method operation from roll-mode record locations », Seiten
4533-4534
IBM TECHNICAL DISCLOSURE BULLETIN, Jahrgang 13, Nr. 5, Oktober 1970, Armonk, US,
W. BEAUSOLEIL : « Shift register storage », Seiten 1336-1337

Speicherhierarchie mit Ladungsverschiebungsspeicher

Die Erfindung betrifft eine Speicherhierarchie nach dem Oberbegriff von Anspruch 1.

Leistungsfähige digitale Rechenanlagen benötigen Digitalspeicher, die sowohl eine große Kapazität als auch geringe Zugriffszeiten aufweisen. Aus technischen und wirtschaftlichen Gründen können diese beiden gewünschten Eigenschaften nicht in einem einzelnen Speicher vereinigt werden ; es werden deshalb Hierarchien von verschiedenen Speichertypen gebildet, bei denen der Prozessor mit dem schnellsten Speicher zusammenarbeitet. Die geringe Kapazität dieses Speichers wird dadurch ausgeglichen, daß die jeweils benötigte Information aus langsameren Speichern großer Kapazität in den schnellen Speicher übertragen wird. Bekannte Beispiele derartiger Speicherhierarchien sind Rechenanlagen mit virtueller Adressierung oder die Verwendung eines schnellen Arbeitsspeichers (Cache) zwischen Prozessor und Hauptspeicher.

Bei den heute verwendeten Speicherhierarchien macht sich der große Unterschied der Zugriffszeiten von elektronischen Speichern (z. B. Halbleiterspeichern) und mechanischen Speichern (z. B. Plattenspeichern) störend bemerkbar ; werden Daten von den mechanischen Speichern zur Verarbeitung benötigt, muß zur Vermeidung des Prozessorstillstands eine Prozeßumschaltung erfolgen, d. h. ein anderer zur Verarbeitung bereiter Prozeß erhält die Kontrolle des Systems. Diese Umschaltung ist ihrerseits zeitaufwendig und erfordert komplexe Steuerungsprozeduren.

Es wäre deshalb wünschenswert, neuartige Speicherelemente in die bekannten Speicherhierarchien einzubauen, deren Zugriffszeiten nur ungefähr ein bis zwei Größenordnungen über der von Halbleiterspeichern liegen. Mit solchen Speichern wäre eine Verwaltung der Hierarchie ohne Prozeßumschaltung möglich ; bei diesem sog. synchronen Hierarchiebetrieb wartet der Prozessor, bis die Daten zum Zugriff in der obersten Hierarchieebene zur Verfügung stehen. Dieser Betrieb ist dann sinnvoll, wenn die Wartezeit des Prozessors in dem Zeitbereich liegt, der auch für die Prozeßumschaltung erforderlich ist.

Die vor einiger Zeit bekannt gewordenen Ladungsverschiebungsspeicher (CCD) weisen Eigenschaften auf, die sie für den Einsatz in Speicherhierarchien zwischen elektronischen und mechanischen Speichertypen geeignet erscheinen lassen. Aufgrund ihres Aufbaus nach Art eines Schieberegisters (oder mehrerer parallel geschalteter Schieberegister mit einem gemeinsamen Ein- und Ausleseregister, sog. « serial-parallel-serial loop » (SPS-)Konzept) liegen die Zugriffszeiten zu beliebigen Datenelementen immer noch im Bereich von einigen hundert Mikrosekunden bis zu mehreren Millisekunden, also zu hoch, als daß auf eine Prozeßumschaltung verzichtet werden könnte.

Die CCD-Speicher sind ihrer Natur nach flüchtige Speicher ; wenn sie nicht adressiert sind und mit ihrer hohen Arbeitsfrequenz arbeiten, müssen sie zur laufenden Auffrischung der gespeicherten Daten mit langsamer Verschiebefrequenz (Ruhefrequenz) betrieben werden. Beim Adressieren eines mit Ruhefrequenz arbeitenden CCD-Speichers, wird der ausgewählte Block mit der hohen Arbeitsfrequenz zur Lese-/Schreibstation transportiert und ebenfalls mit hoher Arbeitsfrequenz gelesen (oder geschrieben). Zur Ausnutzung der hohen Speicherdichte dürfen die einzelnen Speicherschleifen nicht zu klein gewählt werden ; bei einer Schleifenkapazität von rund einem Kilobyte und einer Arbeitsfrequenz von einem Megabit pro Sekunde, beträgt die mittlere Zugriffszeit beispielsweise 5 Millisekunden, entsprechend einem halben Schleifenumlauf.

Zur Reduzierung der mittleren Zugriffszeit für Schieberegister nach Art der CCD's wurde schon vorgeschlagen (deutsche Auslegeschrift 2 165 765), die gespeicherten Informationen im Schieberegister so umzuordnen, daß auf die zuletzt gelesene Information sofort wieder zugegriffen werden kann. Dazu werden im Schieberegister zusätzliche Datenwege und eine Zugriffssteuerung vorgesehen.

Ein weiteres Verfahren zur Reduzierung der mittleren Zugriffszeit zu CCD Speichern wird in dem Artikel « Optimal Shift Strategy for a Block-Transfer CCD Memory » von R. L. Sites in Communications of the ACM, Vol. 21, Nr. 5, 1978, Seite 423 beschrieben ; dort werden die beiden verschiedenen Verschiebefrequenzen eines CCD Speichers ausgenutzt, um den bei einem Zugriff erforderlichen Anfang eines Datenblocks möglichst lange in unmittelbarer Nähe vor dem Lesekopf des CCD Speichers festzuhalten, indem immer dann auf die niedere Verschiebefrequenz umgeschaltet wird, wenn der Blockanfang eine bestimmte Speicherposition (Vorschubposition) vor dem Lesekopf erreicht hat. Die optimale Lage dieser Vorschubposition hängt von den Eigenschaften des verwendeten CCD Speichers ab. Ein ähnliches Verfahren für MOS-Schieberegister ist in dem Artikel « Operation And Application of MOS Shift Registers » von M. E. Hoff und S. Mazor in Computer Design, Februar 1971, Seite 57 ff. beschrieben. Bei rasch hintereinander erfolgenden Zugriffswünschen zum CCD Speicher ist die mit diesen Verfahren erreichte Verringerung der mittleren Latenzzeit noch nicht ausreichend, da immer noch ein Vorschub über beträchtliche Teile der CCD Schleife erfolgen muß ; außerdem stört die hohe Verlustleistung bei häufiger Verwendung der schnellen Verschiebefrequenz.

Die Erfindung stellt sich somit die Aufgabe, die mittlere Zugriffszeit (Latenzzeit) in einer Speicherhierarchie der eingangs genannten Art weiter zu verringern und insbesondere die Notwendigkeit zu beseitigen, bei jedem Zugriff die Vorschubposition mit der hohen Verschiebefrequenz anzusteuern.

Diese Aufgabe wird durch die im Hauptanspruch gekennzeichnete Erfindung gelöst ; Ausgestaltungen der Erfindung sind in den Unteransprüchen enthalten.

Kurz zusammengefaßt gehört zur Erfindung eine Ausführungsform mit einer Speicherhierarchie aus einem schnellen Speicher mit wahlfreiem Zugriff (RAM) und einem Ladungsverschiebungsspeicher (CCD). Die in der Hierarchie übertragenen Datenblöcke sind in einer oder in mehreren CCD-Schleifen enthalten.

Zur Verringerung der mittleren Zugriffszeit eines CCD Speichers wird für jeden darin gespeicherten Block der Folgeblock bestimmt, zu dem mit höchster Wahrscheinlichkeit der nächste Zugriff erfolgt. Dieser Folgeblock wird so in den CCD Speicher geladen, daß zwischen ihm und dem unmittelbar vorher auszulesenden CCD Speicherblock weitere Blöcke eingeschoben werden, so daß der Folgeblock gerade die Vorschubposition erreicht, wenn der Vorgängerblock ausgelesen wird. Die Vorschubposition in der CCD Schleife ist so gewählt, daß der mit niederer Verschiebefrequenz bewegte Folgeblock die Lesestation in den meisten Fällen noch nicht oder gerade erreicht hat, wenn die nächste Zugriffsanforderung zum CCD Speicher erfolgt. Die optimale Lage dieser Vorschubposition wird entsprechend den Parametern des CCD Speichers und der zeitlichen Verteilung der Zugriffswünsche zum CCD Speicher bestimmt.

Erfolgt innerhalb des mittleren zeitabschnittes zwischen zwei CCD. Zugriffen kein Zugriff zu diesem ausgewählten Block, wandert er also ohne gelesen zu werden mit langsamer Geschwindigkeit unter dem Leseschreibkopf vorbei, so wird er anschließend wieder mit hoher Geschwindigkeit in die Ausgangsposition zum Umschalten auf langsame Geschwindigkeit gebracht.

Die optimale Blockbelegung in der CCD Schleife mit Blöcken, die zwischen dem Vorgänger und dem Folgeblock angeordnet sind, kann durch eine Modifizierung des Ersetzungsalgorithmus auch beibehalten werden, wenn einzelne CCD Blöcke auf Hintergrundspeicher verdrängt werden.

In einer Hierarchie mit virtuellen Adressen kann in erster Näherung angenommen werden, daß die Blöcke sequentiell mit aufsteigenden virtuellen Adressen verarbeitet werden. Nach dem Lesen des Blocks mit der virtuellen Adresse n wird bei diesem Modell der CCD-Block mit der Adresse n + 1 in die Position des Folgeblocks gebracht.

In einer anderen Ausführungsform wird der Block mit der höchsten Zugriffswahrscheinlichkeit bestimmt, indem die Folge der vergangenen Blockzugriffe analysiert wird. Bei vielen Programmen kann davon ausgegangen werden, daß bei Aufruf eines bestimmten Blocks mit einer gewissen Konstanz immer dieselben Folgeblöcke in derselben Reihenfolge aufgerufen werden.

Wird diese Folge der Aufrufe registriert, so kann bei einem späteren Aufruf desselben Blocks mit hoher Wahrscheinlichkeit auf die zu erwartenden Nachfolgeblöcke geschlossen und diese entsprechend in die Position der Folgeblöcke gebracht werden.

Die Reduzierung der Zugriffszeit innerhalb der Hierarchie erfordert somit keine teuren Steuerschaltungen oder besondere Datenpfade. Das vorgeschlagene Verfahren ist sehr flexibel und kann durch geeignete Wahl der Hierarchieparameter, wie beispielsweise Blockgröße, Aufteilung der Blöcke auf den CCD-Speicher, Auswahl des Blocks mit der größten Zugriffswahrscheinlichkeit optimiert und an verschiedene Bedingungen angepaßt werden. Von besonderem Interesse ist die automatische Auswahl des Blocks mit der höchsten Zugriffswahrscheinlichkeit durch das System selbst aufgrund des bisherigen Programmablaufs. Das erfindungsgemäße Verfahren kann alleine oder zusammen mit anderen Maßnahmen zur Optimierung einer Speicherhierarchie angewandt werden.

Ein Ausführungsbeispiel der Erfindung wird nun anhand von Zeichnungen näher erläutert. Es zeigen :

Figur 1 ein Prinzipschaltbild einer Hierarchie mit einem CCD-Speicher,

Figur 2 eine Tabelle des teilassoziativen Auswahlspeichers für die Folgeseite,

Figur 3 die Belegung des CCD-Speichers mit vorsortierten Datenblöcken,

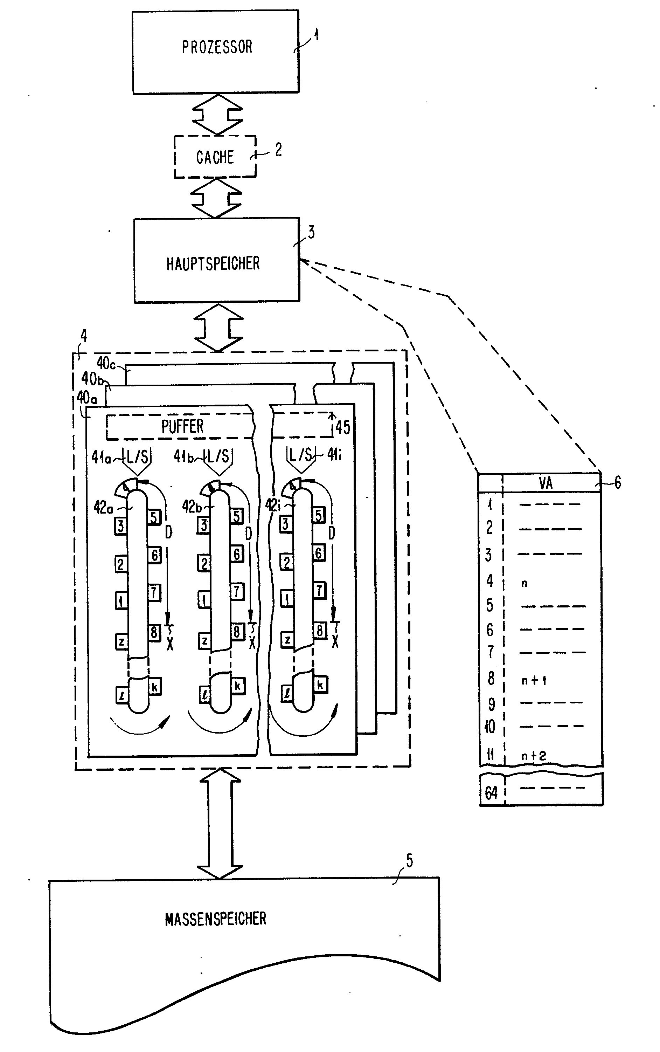

Fig. 1 zeigt in schematischer Weise einen Prozessor 1, der mit einer Speicherhierarchie zusammenarbeitet. Die Hierarchie besteht beispielsweise aus einem schnellen Arbeitsspeicher (Cache) 2, einem Hauptspeicher 3, einem aus Ladungsverschiebungselementen aufgebauten Speicher 4 und einem Massenspeicher 5, beispielsweise Platten- oder Kassettenspeichern. Der Cache-Speicher 2 ist nicht in allen Speicherhierarchien vorhanden, sondern wird nur bei leistungsfähigen Anlagen eingebaut. Der CCD-Speicher 4 soll die « Zugriffslücke » zwischen dem Hauptspeicher 3 und dem Massenspeicher 5 mit langen Zugriffszeiten schließen.

Die Erfindung betrifft im wesentlichen das Zusammenspiel zwischen Hauptspeicher 3 und CCD-Speicher 4. Wenn der CCD-Speicher 4 eine genügend große Kapazität aufweist, kann auch der Massenspeicher 5 entfallen, so daß sich die Hierarchie auf die Elemente 3 und 4 reduziert.

Zum physikalischen Aufbau der Hierarchie können entsprechend der Darstellung in Fig. 1 speziell dafür vorgesehene Speicheranschlüsse verwendet werden, es ist aber auch möglich, die einzelnen Elemente der Hierarchie über eine gemeinsame Sammelleitung miteinander zu verbinden.

Die Verwaltung der Speicherhierarchie und die Steuerung von Zugriffswünschen des Prozessors erfolgt im allgemeinen mit Hilfe virtueller Adressen. Der virtuelle Adreßraum kann dabei in verschiedener Weise auf die vorhandenen Elemente der Speicherhierarchie abgebildet werden.

In der Hierarchie nach Fig. 1 können beispielsweise die Speicher 4 und 5 als Hintergrundspeicher für den Hauptspeicher 3 betrieben werden ; in diesem Fall enthalten sie die aus dem Hauptspeicher ausgelagerten Programmteile mit nicht aktiven virtuellen Adressen. In einer anderen Betriebsform können die Speicher 3 und 4 zusammen als erweiterter Hauptspeicher mit durchgehendem Adreßbereich aufgefaßt werden, mit dem Massenspeicher 5 als zugehörigen Hintergrundsspeicher. Einzelheiten dieser verschiedenen Betriebsformen werden später im einzelnen betrachtet.

Der CCD-Speicher 4 besteht aus einem Modul mit einer Anzahl von Speicherplättchen 40a, 40b, die jeweils mehrere Speicherschleifen 42a, 42b mit zugeordneten Lese/Schreibköpfen L/S 41a, 41b enthalten. Ein Pufferbereich 45 für das Ein-/Auslesen in die Speicherschleifen steht bei manchen Ausführungsformen von CCD-Speicherplättchen zur Verfügung. Aufbau und Wirkungsweise von CCD-Speichern sind im Stand der Technik bekannt und beispielsweise in der Veröffentlichung « Aufbau, Organisation und Einsatz von Ladungstransport-(CCD-) Speichern » von H.-J. Harloff, NTG-Fachberichte, Bd, 58, Berlin 1977, Seite 146 beschrieben.

Die im CCD-Speicher 4 enthaltenen Daten sind in Datenblöcke aufgeteilt. Die Verteilung der einzelnen Bits eines Datenblocks auf die verschiedenen Speicherplättchen kann beispielsweise entsprechend Fig. 1 erfolgen. In der jeweils ersten Schleife 42a eines jeden der neun Speicherplättchen ist ein Bit eines Bytes (8 Datenbits und ein Paritätsbit) gespeichert. Jedes Speicherplättchen besitzt z. B. 128 Schleifen 42. Die Speicherkapazität einer Schleife beträgt beispielsweise 2 Kilobit. Jede Schleife ist in 64 Unterblöcke mit je 32 Bits aufgeteilt. Ein Datenblock mit 4 K-Byte belegt somit einen der Unterblöcke einer jeden Speicherschleife.

Innerhalb eines Speichermoduls BSM laufen die einzelnen Speicherschleifen synchron um. Zum Ein- und Auslesen eines 4 K-Datenblocks müssen alle Speicherschleifen daher um 32 Bitpositionen unter den Lese-/Schreibköpfen 41 vorbeigeführt werden.

Um die Zeiten für das Ein-/Auslesen eines Datenblocks nicht zu groß werden zu lassen, und um die Sammelleitungen zu Haupt- oder Massenspeicher nicht zu lange zu belegen, erfolgt der Datenaustausch mit diesen Hierarchiekomponenten in kleineren Blöcken, beispielsweise 128 Bytes. Für einen derartigen Datenaustausch sind dann bei einer Taktfrequenz des CCD-Speichers von einem Megabit pro Sekunde 128 Mikrosekunden erforderlich.

Soll an einer beliebigen Stelle einer Speicherschleife Information eingeschrieben oder ausgelesen werden, so ist bei der obengenannten Organisation im Mittel eine Latenzzeit von $1/2 \cdot 4$ Kilobit $\cdot 10^{x6}$ Sekunde/Bit $= 2$ Millisekunden erforderlich.

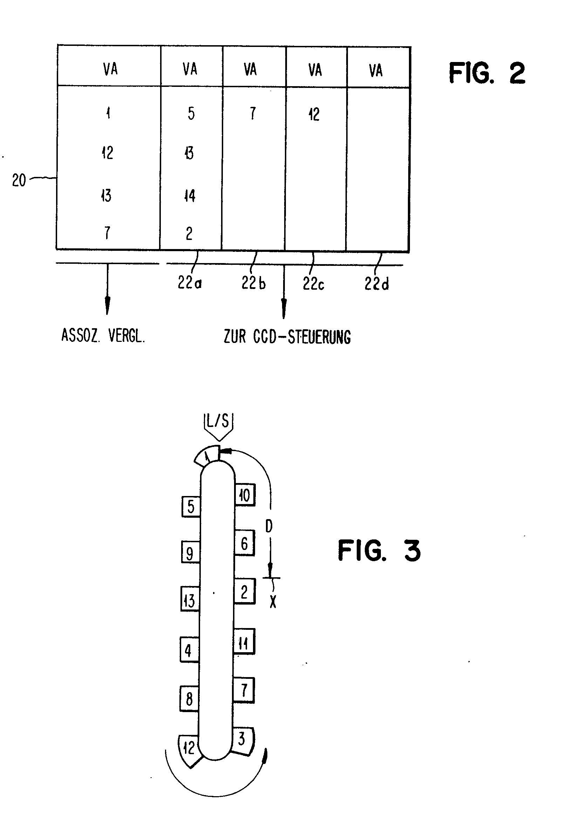

Zur Reduzierung dieser Latenzzeit schlägt die Erfindung vor, beim Laden der Programmblöcke eines Prozesses in den CCD Speicher die Blöcke in der Reihenfolge ihrer voraussichtlichen Anforderung anzuordnen und dabei zwischen aufeinanderfolgenden Blöcken (Vorgängerblock und Folgeblock) andere Blöcke so einzuschieben, daß nach dem Lesen eines Vorgängerblocks der Folgeblock mit der höchsten Wahrscheinlichkeit für den nächsten Zugriff an der in Fig. 1 und Fig. 3 mit X bezeichneten Stelle (Vorschubposition) liegt, die gerade den für die Geschwindigkeitsumschaltung optimalen Abstand vom Lesekopf L/S aufweist. Fig. 3 zeigt ein Beispiel einer Speicherschleife mit 13 Blöcken ; zwischen je zwei Blöcken mit aufeinanderfolgender Numerierung (z. B. 1 und 2) sind zwei weitere Blöcke eingefügt. Der nach dem Verarbeiten des Blocks 1 nachfolgend auslesender Folgeblock 2 befindet sich damit in der gewünschten Vorschubposition X.

Nach dem Lesen des Blocks 1 wird der Taktgeber des CCD-Speichermoduls auf die langsame Fortschaltegeschwindigkeit (Ruhefrequenz) umgeschaltet, beispielsweise auf 10 % der maximalen Geschwindigkeit, im Beispiel also 100 Kilobit/Sekunde.

Bei dem Beispiel in Fig. 1 liegen zwischen der Vorschubposition X und dem Lese-/Schreibkopf 41 (bzw. dem Ende des Blocks 4) drei Blöcke mit je 32 Bits. Bis der Block mit der Bezeichnung 8 den Lese-/Schreibkopf 41 erreicht, vergeht bei der langsamen Fortschaltegeschwindigkeit ungefähr eine Millisekunde. Innerhalb dieses Zeitraums besteht eine hohe Wahrscheinlichkeit, daß der Vorgängerblock vom Prozessor verarbeitet wurde und eine neue Anforderung an den CCD-Speicher für einen Lese- oder Schreibvorgang gestellt wird. Durch geeignete Wahl der Parameter, insbesondere des Abstandes zwischen der Vorschubposition X und dem Lese-/Schreibkopf, kann, wie aus dem Stand der Technik bekannt, erreicht werden, daß der Block mit der höchsten Zugriffswahrscheinlichkeit im Mittel gerade dann am Lese-/Schreibkopf erscheint, wenn die entsprechende Zugriffsanforderung gestellt wird. Erscheint die nächste Anforderung bevor der Block den Lese-/Schreibkopf erreicht, wird zum restlichen Vorschub wieder die hohe Fortschaltgeschwindigkeit gewählt. Durch den Vorschub zur Stelle X wird desshalb im Mittel nur noch die Hälfte der Entfernung zwischen Vorschubstelle X und Lese-/Schreibkopf nach Eintreffen einer Zugriffsanforderung mit hoher Fortschaltegeschwindigkeit zurückgelegt werden müssen, d. h. aber die Latenzzeit verringert sich auf ungefähr 50 Mikrosekunden (anstelle von vorher zwei Millisekunden). Während dieser kurzen Zeitspanne kann der Prozessor in den Wartezustand übergehen und braucht keine Prozeßumschaltung mehr durchzuführen. Prozessor und Speicherhierarchie arbeiten somit im synchronen Betrieb.

Die Bestimmung des Blocks mit der höchsten Wahrscheinlichkeit für den nächsten Zugriff erfolgt bei einer mit virtuellen Adressen arbeitenden Speicherhierarchie unter der Annahme, daß Blöcke mit aufsteigenden virtuellen Adressen sequentiell zu verarbeiten sind. (In Systemen mit virtuellen Adressen kann anstelle des Ausdrucks « Block » auch « Seite » verwendet werden). Nach der Bearbeitung des Blocks mit der virtuellen Adresse n. liegt also der Block mit der virtuellen Adresse n + 1 mit großer Wahrscheinlichkeit in der Vorschubposition X ; im andern Fall muß er dorthin mit hoher Fortschallgeschwindigkeit gebracht werden.

Aus dem Inhaltsverzeichnis 6 (Fig. 1) des CCD-Speichers (das wegen des schnellen Zugriffs im Hauptspeicher 3 aufbewahrt wird), ist ersichtlich, daß im Beispiel nach Zugriff zu Block 8 der Block 11 die gewünschten virtuellen Adressen (VA) enthält. In der ersten Spalte des Inhaltsverzeichnisses 6 ist die Nummer der CCD-Datenblock angegeben ; die Belegung des Inhaltsverzeichnisses mit virtuellen Adressen ist willkürlich. Die maximale Zahl Z der Unterblöcke jeder Schleife beträgt Z = 64.

Ein weiteres Verfahren zur Bestimmung des Blocks (oder der Blöcke) mit der höchsten Wahrscheinlichkeit des nächsten Zugriffs, ist in Fig. 2 dargestellt. Ein Speicher 20 mit einem assoziativen Teil 21 enthält während des Programmablaufs jeweils die (virtuelle) Adresse VA des gerade aktiven Blocks. In zugehörigen, nicht assoziativen Speicherteilen 22a bis 22d, werden die Adressen der Blöcke eingetragen, auf die vom jeweils aktiven Block zugegriffen wurde. Hierfür können beispielsweise vier bis acht Speicherstellen vorgesehen werden.

Wird während des Programmablaufs ein bisher aktiver Block aus dem Hauptspeicher in den CCD-Speicher verdrängt, und unter möglichster Berücksichtigung des gewürschten Blockabstandes zu seinem Folgeblock dort abgelegt so bleibt der Eintrag im Speicher 20 bestehen. Bei späteren Zugriffen zu diesem Block (d. h., bei erneuter Übertragung des Blockes vom CCD-Speicher in den Hauptspeicher) werden die von diesem Block beim früheren Aufruf referierten Blöcke mit der Hilfe der Einträge im Speicher 20 gefunden.

Unter der Annahme, daß beim erneuten Aufruf dieser Seite dieselbe Zugriffssequenz durchlaufen wird, können die Latenzzeiten des CCD-Speichers nach der oben angegebenen Vorschrift reduziert werden.

Diese Annahme ist insbesondere für komplexe Programme berechtigt, die von verschiedenen Komponenten des Betriebssystems und anderer Systemsteuerprogramme Gebrauch machen. Ein Beispiel hierfür sind Programme zur Fernverarbeitung von Daten. Die eigentlichen Problemprogramme sind in diesem Bereich von mehreren Schichten Systemprogrammen überlagert, die während des Programmablaufs nacheinander durchlaufen werden. Auf diese Weise ergibt sich eine immer wieder auftretende Zugriffsfolge auf Speicherblöcke mit Instruktionen (oder auch Daten), die für die Bestimmung der Seite mit der höchsten Zugriffswahrscheinlichkeit ausgenutzt werden könnte.

Als Beispiel sei ein Programm betrachtet, bei dessen Ablauf nacheinander folgende Blöcke angesprochen werden (Zugriffsfolge)

$$1 \rightarrow 5 \rightarrow 1 \rightarrow 7 \rightarrow 5 \; (= \text{Datenzugriff})$$
$$\rightarrow 1 \rightarrow 12 \rightarrow 13 \rightarrow 14 \rightarrow 1 \rightarrow 7 \rightarrow 2$$

Zu Beginn der Programmausführung soll der Hauptspeicher keine Blöcke enthalten ; jedesmal, wenn ein Block aus dem CCD-Speicher in den Hauptspeicher gebracht wird, erfolgt ein Eintrag im nicht-assoziativen Teil der Zeile, die dem aufrufenden Block zugeordnet ist. (Der aufrufende Block ist im assoziativen Teil dieser Zeile registriert.)

Ist bei einer Übertragung aus dem CCD-Speicher in den Hauptspeicher dem aufrufenden Block noch keine Zeile in der Tabelle nach Fig. 2 zugeordnet, so wird die virtuelle Adresse des aufrufenden Blöcke in den assoziativen Teil einer freien Zeile eingetragen.

Aufrufe von Blöcken, die sich schon im Hauptspeicher befinden, werden in die Tabelle nicht eingetragen. Die Tabellenbelegung, die sich damit für die oben dargestellte Zugriffsfolge ergibt, ist in Fig. 2 gezeigt. Die Überprüfung, ob für einen aufrufenden Block schon eine Zeile in der Tabelle vorgesehen ist, erfolgt durch assoziativen Vergleich der aktuellen Blockadresse mit den Einträgen auf der ersten Tabellenspalte.

Wenn die Tabelle überläuft, wird der älteste Eintrag (dessen Benutzung am weitesten zurückliegt), überschrieben.

Der nicht-assoziative Teil der Tabelle nach Fig. 2 wird an die CCD-Steuerung ausgegeben, wenn im späteren Programmverlauf erneut ein (inzwischen in den CCD-Speicher verlagerter Block) im assoziativen Teil der Tabelle aufgeführter Block in den Hauptspeicher übertragen wird.

Mit den aus der Tabelle ausgelesenen Adressen der registrierten Folgeseiten werden die betreffenden Blöcke im CCD-Speicher an entsprechenden Positionen geladen, bzw. in Vorschubposition X gebracht.

Wenn der CCD-Speicher aus mehreren Moduls 4 (in Fig. 1) besteht, die unabhängig voneinander betrieben werden können (d. h., eine eigene Taktsteuerung aufweisen) und die Programmblöcke mehr oder weniger gleichmäßig auf die Moduls verteilt sind, können die auf verschiedenen Moduls angeordneten Folgeblöcke (entsprechend den Adressen in der Tabelle nach Fig. 2) gleichzeitig vorsorglich in die jeweilige Vorschubposition X der einzelnen CCD-Moduls geladen werden.

Die bisherige Diskussion beruhte auf der Annahme, daß der Block mit der höchsten Zugriffswahrscheinlichkeit im CCD-Speicher 4 enthalten ist. Diese Annahme wird im Normalfall erfüllt sein, da die große Kapazität des CCD-Speichers (einige hundert Kilobytes pro Modul) es erlauben wird, bei Aktivierung eines Prozesses alle zugehörigen Blöcke vom Massenspeicher in den CCD-Speicher zu übertragen. In den anderen Fällen mußte der fehlende Block in der üblichen Weise vom Hintergrundsspeicher (Massenspeicher) in den CCD-Speicher während des Programmablaufs übertragen werden.

Wenn kein Massenspeicher verwendet wird, bleibt die Reihenfolge der Blöcke im CCD-Speicher während des Betriebs der Speicherhierarchie erhalten; ein aus dem CCD-Speicher in den Hauptspeicher übertragener Block wird im CCD-Speicher an die ursprüngliche Stelle zurückgeschrieben, wenn er im weiteren Programmverlauf aus dem Hauptspeicher wieder verdrängt wird.

Im Hauptspeicher wird vorzugsweise immer ein Speicherblock für einen neu einzulesenden Block freigehalten; während der Bearbeitung dieses Blocks kann dann wieder ein Speicherblock frei gemacht werden, indem der am wenigsten benutzte Block im Hauptspeicher an seine ursprüngliche Stelle im CCD-Speicher zurückgeschrieben wird.

Findet auch zwischen CCD-Speicher und dem Massenspeicher während der Bearbeitung eines Prozesses ein Datenaustausch innerhalb der Hierarchie statt, so wird diese Reihenfolge gestört, da Blöcke aus dem CCD-Speicher in den Massenspeicher verdrängt werden und neue Blöcke einzuschreiben sind. In diesem Fall kann zur Leistungsoptimierung des CCD-Speichers ein Ersetzungsalgorithmus für die aus dem CCD-Speicher zu verdrängenden Seiten gewählt werden, der die Reihenfolge dieser Seiten möglichst wenig stört. Für das Beispiel des bekannten least recently used (LRU)-Algorithmus kann dies so erfolgen, daß nicht die tatsächlich am wenigsten benutzte Seite aus dem CCD-Speicher verdrängt wird, sondern diejenige Seite unter den 8 am wenigsten benutzten Seiten, die zur geringstmöglichen Störung der aufsteigenden Reihenfolge der Seiten im CCD-Speicher führt. Dies sei an folgendem Beispiel verdeutlicht: Die Reihenfolge der Blöcke im CCD-Speicher sei 1, 2, 4, 6, 7, 9, 10. Der neu einzuschreibende Block trage die Nummer 3. Der am wenigsten benutzte Block im CCD-Speicher sei 9. Die Blöcke mit der nächst geringeren Benutzungshäufigkeit seien 10, 7 und 4. Um die Reihenfolge der Blöcke wenig zu stören, wird in diesem Fall der Block 4 ausgelagert und an dessen Stelle der Block 3 in den CCD-Speicher eingeschrieben. Bei einer nicht zu vermeidenden Störung der Blockanordnung, wie sie hier vorgeschlagen wurde, kann das im Stand der Technik beschriebene Verfahren der schnellen Fortschaltung zur Vorschubposition X zusätelich angewandt werden.

Zur weiteren Leistungsverbesserung einer derartigen Speicherhierarchie mit CCD-Speichern können folgende Maßnahmen dienen: Verwendung zweier Pufferspeicher 45 in Fig. 1, die abwechselnd zum vorausschauenden Laden der Seite mit der höchsten Zugriffswahrscheinlichkeit Verwendung finden,

Verwendung mehrerer CCD-Speichermodule mit jeweils unabhängigen Taktgebern und verschränkter Aufteilung der Datenblöcke auf die verschiedenen Moduls,

Trennung von Datenblöcken mit Instruktionen einerseits und Eingabe-/Ausgabedaten andererseits.

## Ansprüche

1. Speicherhierarchie mit einem Hauptspeicher und einem nachgeschalteten Umlaufspeicher, beispielsweise einem Ladungsverschiebungsspeicher (CCD), der zwei verschiedene Transportgeschwindigkeiten für die gespeicherten Daten aufweist und bei dem nach einem Speicherzugriff das Datenelement für den nächsten Zugriff mit hoher Geschwindigkeit (Arbeitsfrequenz) in eine Position (Vorschubposition X; Fig. 1) gebracht werden kann, von der aus das Datenelement die Zugriffsstation (Lese-/Schreibkopf L/S 41) des Umlaufspeichers nach Umschalten in die niedere Geschwindigkeit (Ruhefrequenz) bis zum Auftreten des nächsten Zugriffs wahrscheinlich gerade erreicht, dadurch gekennzeichnet, daß beim Laden der Datenelemente in den Umlaufspeicher zwischen jeweils zwei Elemente, zu denen mit hoher Wahrscheinlichkeit nacheinan der zugegriffen wird (z. B. Vorgängerblock 1, Folgeblock 2; Fig. 3), andere Elemente (z. B. Block 6, 10) eingeschoben werden, wobei der Abstand zwischen den beiden Elementen so gewählt wird, daß beim Zugriff zum ersten Element das zweite Element die Vorschubposition (X) erreicht.

2. Speicherhierarchie nach Anspruch 1, dadurch gekennzeichnet, daß die Daten im Umlaufspeicher in Blockform (Datenblöcke) gespeichert sind.

3. Speicherhierarchie nach Anspruch 1, dadurch gekennzeichnet, daß die Datenblöcke virtuell adressiert sind und daß als wahrscheinlichste Zugriffsfolge die Datenblöcke mit aufsteigenden virtuellen Adressen ausgewählt werden.

4. Speicherhierarchie nach Anspruch 3, dadurch gekennzeichnet, daß die Bestimmung der Datenblöcke mit aufsteigenden virtuellen Adressen mit Hilfe eines im Hauptspeicher enthaltenen Inhaltsverzeichnisses (6) der Datenblöcke im Umlaufspeicher erfolgt.

5. Speicherhierarchie nach Anspruch 1, dadurch gekennzeichnet, daß zur Bestimmung des Datenblocks mit der höchsten Wahrscheinlichkeit für den nächsten Zugriff die während des Programmablaufs auftretenden Zugriffsfolgen für jeden Datenblock registriert werden.

6. Speicherhierarchie nach Anspruch 1, dadurch gekennzeichnet, daß eine Tabelle (20; Fig. 2) vorgesehen ist, in deren assoziativ zugreifbarem Teil die Identifizierung (z. B. virtuelle Adresse) von Datenblöcken eingetragen wird, die andere Datenblöcke aufrufen und in deren mehrfach vorhandenen, nicht-assoziativen Teilen (22a, b, c, d) die Identifizierung der angesprochenen Datenblöcke eingetragen wird, die vom Umlaufspeicher (4) in den Hauptspeicher übertragen werden.

7. Speicherhierarchie nach einem der Ansprüche 1 bis 6, dadurch gekennzeichnet, daß bei der Auslagerung einzelner Datenblöcke aus dem Umlaufspeicher in nachgeordnete Speicher derjenige Datenblock ausgewählt wird, dessen Ersatz die geringste Störung der Zugriffsreihenfolge im Umlaufspeicher bewirkt.

8. Speicherhierarchie nach einem der Ansprüche 1 bis 7, dadurch gekennzeichnet, daß der Folgeblock mit hoher Transportfrequenz in die Vorschubposition (X) gebracht wird, wenn er sich nach dem Zugriff zum Vorgängerblock nicht in der Vorschubposition (X) befindet oder die Zugriffsstation erreicht hat, ohne daß ein Zugriff erfolgt ist.

**Claims**

1. Storage hierarchy with a main storage and a cyclic storage of a lower level, for example, a charge-coupled device (CCD) storage having two different transfer speeds for the stored data and wherein after a storage access, the data element to be accessed next is moved at high speed (operating frequency) to a position (shift position X ; Fig. 1) from which the data element is likely to reach the access station (read/write head /LS 41) of the cyclic storage, after it has been switched to the lower speed (standby frequency), at the very time the next access is effected, characterized in that upon loading the data elements into the cyclic storage, other elements (e. g., blocks 6, 10) are introduced between every two elements which are likely to be successively accessed (e. g., predecessor block 1, successor block 2 ; Fig. 3), the distance between the two elements being chosen in such a manner that upon access to the first element, the second element reaches the shift position (X).

2. Storage hierarchy according to claim 1, characterized in that the data are stored in the cyclic storage in block form (data blocks).

3. Storage hierarchy according to claim 1, characterized in that the data blocks are virtually addressed, and that the data blocks with ascending virtual addresses are chosen as the most likely access sequence.

4. Storage hierarchy according to claim 3, characterized in that the data blocks with ascending virtual addresses are determined by means of a directory (6) of the data blocks in the cyclic storage, which is contained in the main storage.

5. Storage hierarchy according to claim 1, characterized in that for determining the data block which is most likely to be accessed next, the access sequences, occurring for each block in the program cycle, are recorded.

6. Storage hierarchy according to claim 1, characterized in that a table (20 ; Fig. 2) is provided into whose associatively accessible part the identification (e. g., the virtual address) of data blocks, invoking other blocks, is entered, and into whose non-associative parts (22a, b, c, d), of which there are several, the identification of the invoked data blocks, transferred from the cyclic storage (4) to the main storage, is entered.

7. Storage hierarchy according to any one of the claims 1 to 6, characterized in that when individual data blocks are transferred from the cyclic storage to storages of a lower level, that data block is selected which, when replaced, interferes least with the access sequence of the cyclic storage.

8. Storage hierarchy according to any one of the claims 1 to 7, characterized in that the successor block is moved at high speed to the shift position (X) if it is not in said position after the predecessor block has been accessed or if it has reached the access station without an access having been effected.

**Revendications**

1. Hiérarchie de mémoire comportant une mémoire principale suivie par une mémoire cycle de niveau inférieur, par exemple une mémoire à décalage de charge (CCD) qui a deux vitesses de transmission différentes pour les données emmagasinées et dans laquelle, après un accès de mémoire, l'élément de données pour l'accès suivant peut être amené à vitesse élevée (vitesse de fonctionnement) dans une position (position de décalage X ; figure 1) à partir de laquelle l'élément de données arrive probablement juste à la station d'accès (tête de lecture/écriture LS 41) de la mémoire cycle après avoir été commuté sur la vitesse réduite (fréquence de repos) jusqu'à l'accès suivant, caractérisé en ce que, en chargeant les éléments de données dans la mémoire cycle, on insère entre les deux éléments de chaque paire d'éléments ayant la probabilité d'être accédés successivement (par exemple bloc prédécesseur 1, bloc successeur 2 ; figure 2) d'autres éléments (par exemple bloc 6, 10), les espaces entre les deux éléments étant choisis de telle sorte que lors de l'accès du premier élément le second élément arrive à la position de décalage (X).

2. Hiérarchie de mémoire selon la revendication 1, caractérisée en ce que les données sont emmagasinées dans la mémoire cycle sous forme de blocs (blocs de données).

3. Hiérarchie de mémoire selon la revendication 1, caractérisée en ce que les blocs de données sont adressés virtuellement, et en ce que les blocs de données ayant des adresses virtuelles ascendantes sont choisis comme séquence d'accès la plus probable.

4. Hiérarchie de mémoire selon la revendication 3, caractérisée en ce que les blocs de données ayant des adresses virtuelles ascendantes sont déterminés à l'aide d'une table des matières (6) des blocs de données de la mémoire cyclique, cette table étant contenue dans la mémoire principale.

5. Hiérarchie de mémoire selon la revendication 1, caractérisée en ce que, pour déterminer le bloc de données ayant la plus grande probabilité d'être accédé ensuite, on enregistre les séquences d'accès utilisées pour chaque bloc de données lors du déroulement du programme.

6. Hiérarchie de mémoire selon la revendication 1, caractérisée en ce qu'une table (20 ; figure 2) est prévue dont la partie accessible par associativité contient l'identification (par exemple adresse virtuelle) de blocs de données qui appellent d'autres blocs de données, et dont les autres parties non-associatives (22a, b, c, d) enregistrent l'identification des blocs de données appelés qui sont transférés par la mémoire cycle (4) dans la mémoire principale.

7. Hiérarchie de mémoire selon l'une des revendications 1 à 6, caractérisée en ce que, en transférant des blocs de données individuels de la mémoire cycle dans des mémoires de niveau inférieur on choisit le bloc de données dont le remplacement perturbe le moins possible la séquence d'accès.

8. Hiérarchie de mémoire selon l'une des revendications 1 à 7, caractérisée en ce que le bloc suivant est amené à une vitesse de transfert élevée dans la position de décalage (X) lorsqu'il ne se trouve pas dans cette position après l'accès du bloc précédent ou lorsqu'il arrive à la station d'accès sans qu'un accès ait été fait.

| VA | VA | VA | VA | VA |
|----|----|----|----|----|
| 1  | 5  | 7  | 12 |    |
| 12 | 13 |    |    |    |
| 13 | 14 |    |    |    |
| 7  | 2  |    |    |    |

**FIG. 2**

22a    22b    22c    22d

ASSOZ. VERGL.          ZUR CCD-STEUERUNG

20

**FIG. 3**

L/S

5   10
9   6
13  2
4   11
8   7
12  3

D
X

2